# EUROPÄISCHE PATENTSCHRIFT

(11) **EP 2 683 084 B1**
(45) Veröffentlichungstag und Bekanntmachung des Hinweises auf die Patenterteilung: **18.11.2015**
(21) Anmeldenummer: 12005950.6
(22) Anmeldetag: 18.08.2012
(51) Int. Cl.: G08B 13/24, H03K 17/955, H03K 17/96

(54) **LKW Diebstahlsicherung mittels Zollschnur**
HGV anti-theft device incorporating a cord
Sécurité contre le vol pour poids lourd au moyen d'une ficelle douanière

(30) Priorität: 06.07.2012 AT 74812 U
(43) Veröffentlichungstag der Anmeldung: 08.01.2014
(73) Patentinhaber: abatec group AG, 4844 Regau (AT)
(72) Erfinder: Niederndorfer, Friedrich, 4840 Pilsbach (AT)

(56) Entgegenhaltungen:
- EP-A2- 1 935 689
- WO-A1-03/024755
- DE-A1- 2 630 683
- DE-A1-102008 005 238
- DE-B- 1 286 607
- FR-A1- 2 263 642
- US-A1- 2011 042 522

## Beschreibung

Die Erfindung betrifft eine elektronische Warnvorrichtung gegen das Eindringen von Personen in einen abzusichernden Bereich wie typischerweise den Laderaum eines Lastkraftwagens.

In den Neunzehnhunderundzwanzigerjahren meldete der russische Wissenschaftler Leo Theremin, Erfinder des Musikinstruments Theremin, eine Reihe von Patenten an, welche sich mit Musikinstrumenten oder mit Näherungs- bzw. Bewegungssensoren befassen, beispielsweise die US 1661058 A, US 1658953 A, DE 443536 C, DE 449075 C, DE 499203 C und DE 540745 C. Die Schriften betreffen elektronische Schaltungen, welche als Ausgangssignal elektrische Wechselspannungen im hörbaren Frequenzbereich liefern und als Teil von Bewegungs- oder Näherungssensoren und/oder von Musikgeräten verwendbar sind. Es werden mindestens zwei hochfrequente elektrische Schwingkreise zur Schwingung angeregt sodass sie Ausgangsseitig jeweils eine hochfrequente Wechselspannung liefern. Von der Spannungsdifferenz zweier hochfrequenten Wechselspannungen wird der niederfrequente Wechselanteil - die sogenannte Schwebung, also die Differenzfrequenz zwischen den beiden hochfrequenten Wechselspannungen - herausgefiltert und ausgewertet und/oder über eine Verstärkerstufe an einen Lautsprechers geführt und somit hörbar gemacht. Zumindest einer der beiden Schwingkreise umfasst eine Induktivität, eine Kapazität und einen Spannungsverstärker (durch eine Röhre realisiert), wobei der Steuereingang und der Betriebsspannungseingang des Spannungsverstärkers mit jeweils einer von zwei Induktivitäten (Spulen) in Serie geschaltet sind, welche miteinander lose magnetisch verkoppelt sind, sodass eine Stromänderung in der einen Spule eine Spannung in der anderen Spule induziert. Schon sehr kleine Veränderungen einer der beiden Induktivitäten oder der Kopplung zwischen den beiden Induktivitäten oder einer weiteren Kapazität, welche zwischen die beiden Induktivitäten geschaltet ist, bewirken dadurch erhebliche Veränderungen der Frequenz des Schwingkreises. Um Veränderungen herbeizuführen, welche ausreichend stark sind, um das Gesamtausgangssignal hörbar zu verändern, reicht es schon aus, dass sich eine Person oder eine Gliedmaße einer Person an Schaltungsteile annähert oder sich davon entfernt. Die Person bzw. die Gliedmaße der Person stellt eine elektrische Kapazität dar, durch welche - eventuell über den Umweg einer gemeinsamen Erdung - eine kapazitive Verbindung zwischen verschiedenen Schaltungsteilen des Schwingkreises verursacht bzw. verändert wird und damit eine Frequenzänderung herbeigeführt wird.

In der WO 8805950 A1 ist eine typischerweise an einem Personenkraftwagen verwendbare Warnvorrichtung gegen Annäherung von Menschen beschrieben. Eine Sendeantenne erzeugt ein gleichmäßig oszillierendes elektromagnetisches Feld; eine im Einflussbereich der Sendeantenne befindliche Empfangsantenne nimmt das elektromagnetische Feld wahr. Das empfangene Signal ändert sich natürlich durch Veränderung der relativen Position der Antennen zueinander aber auch durch das Annähern eines, das elektromagnetische Feld beeinflussenden, Körpers. Änderungen des empfangenen Signals werden erfasst und ausgewertet und automatisiert als Entscheidungsgröße verwendet ob Alarm ausgelöst wird oder nicht.

Die US 5227764 A zeigt einen in einem Fahrzeug anbringbaren elektronischen Sensor für Annäherung und Bewegung von Personen. Ein elektrischer Schwingkreis sendet elektromagnetische Wellen im GHz-Bereich aus. Die Bewegung einer Person im Nahbereich wirkt dahingehend auf den Sender zurück, dass es an diesem zu niederfrequenteren Schwankungen der abgestrahlten Energie kommt. Diese Schwankungen werden messtechnisch erfasst und ausgewertet und können sofern sie signifikant sind, zu einem Alarm führen.

Die DE 698 22 970 T2 schlägt vor, als Sensorgröße für das Feststellen der Annäherung eines Benutzers eines Fahrzeuges an das Fahrzeug jene elektrische Kapazität zu verwenden, welche jener Kondensator hat, welcher durch eine von der Fahrzeugmasse elektrisch isolierten Fläche des Fahrzeuges und einer sich an diese Fläche annähernden Hand des Benutzers gebildet wird. Für die Messung wird die Kapazität des aus dieser Fläche und Fahrzeugmasse gebildeten Kondensators bei sehr hoher Messfrequenz gemessen, wozu die besagte Fläche gegenüber Fahrzeugmasse mit einer hochfrequenten, dem Betrag nach aber natürlich sehr niedrigen elektrischen Spannung beaufschlagt wird. Wenn derart eine Annäherung detektiert wird, wird ein System für die Fernerkennung des Benutzers eingeschaltet und in Abhängigkeit von dessen Ergebnissen wird das Schloss des Fahrzeuges entriegelt oder nicht.

Die EP 1 160 400 B1 beschreibt ein zur DE 698 22 970 T2 verwandtes Prinzip für das Feststellen der Annäherung eines Benutzers an ein Fahrzeug. Als Signalverarbeitung wird die besagte Kapazitätsänderung in eine Frequenzänderung eines Schwingkreises umgewandelt und die Frequenzänderung mittels Frequenzfiltern in eine Spannungsänderung.

Die GB 2 390 164 B schlägt eine Sensoranordnung dafür vor, das Eindringen einer Person in das von einer LKW-Plane umspannte Gebiet zu detektieren. Dazu werden an der Innenseite der Plane elektrische Kondensatoren in Form von Streifen angebracht, welche zwei leitfähige Schichten und eine diese trennende, nicht allzu dünne Isolierschicht aufweisen. Die Kondensatoren werden mit Wechselspannung hoher Frequenz beaufschlagt. Durch das Annähern einer Person an einen derartigen Kondensator wird dessen Kapazität verändert. Diese Veränderung wird messtechnisch erfasst.

Die WO 2003024755 A1 beschreibt ein Einbruchswarnsystem für einen Lastkraftwagen. Die Kabine ist mit einem passiven Infrarotsensor ausgestattet. Für das Sichern des durch eine Plane ummantelten Laderaums ist die Plane mit daran angebrachten elektrischen Leitern versehen deren durchgehende Leitfähigkeit gemessen wird. Wenn die Leitfähigkeit unterbrochen ist, weil die Plane und mit dieser ein elektrischer Leiter durchschnitten wurde, wird Alarm ausgelöst. Auch die sogenannte Zollschnur, also jene Schnur, welche bei geschlossener Plane sowohl durch Ösen an den Rändern der Plane als auch durch Öffnungen am angrenzenden starren Fahrzeugteil verläuft, und somit die Plane sichert, ist mit einem derartigen Leiter versehen. Durchschneiden der Zollschnur bewirkt unterbrechen des Leiters und damit Alarmauslösung.

Auch in der WO 8706749 A1 wird vorgeschlagen die flexible Umhüllung des Laderaums sowohl in den flächigen Teilen als auch an den Verbindungsstellen mit anderen Teilen mit elektrischen Leitern zu versehen, und vorzusehen dass bei Unterbrechung eines Leiters automatisch Alarm ausgelöst wird.

In der EP 1 935 689 A2 wird vorgeschlagen, anstatt der Zollschnur einen Schlauch zu verwenden, in welchem ein Fluiddruck aufgebaut und aufrechterhalten wird. Wenn der Druck absinkt, ist dies ein Hinweis darauf, dass der Schlauch aufgeschnitten oder durchschnitten wurde und dementsprechend wird Einbruchsalarm gegeben.

Die DE 10 2008 005 238 A1 beschreibt einen Diebstahlsüberwachungsvorrichtung für ein elektrisches Gerät, wobei ein frei schwingender elektrischer Oszillator verwendet wird, bei welchem die Schwingungsfrequenz durch eine Induktivität beeinflussbar ist, wobei diese Induktivität durch die Primärwicklung eines Transformators gebildet ist, welche mit einem Pol an Erde gelegt ist. Die Sekundärwicklungen des besagten Transformators sind durch Leistungen die zu dem zu überwachenden Gerät führen gebildet, wozu diese Leitungen in mehreren Wicklungen zum den Transformaterkern geschlungen sind. Die Sekundärwicklungen sind ebenfalls über jeweils einen Kondensator mit Erde verbunden. Wenn an jener Leitung welche die Sekundärwicklung darstellt hantiert wird, ändert sich deren Impedanz, was auf die Induktivität der Primärwicklung zurückwirkt und damit die Schwingungsfrequenz des Oszillators verändert. Die Schwingungsfrequenz wird elektronisch überdacht, bei zu starker Änderung wird ein Alarmsignal ausgegeben. Die Überwachungsvorrichtung funktioniert nur für relativ niedrige Schwingungsfrequenzen (10 bis 40 kHz) des Oszillators und für noch niedrigere Frequenzen der Betriebsspannung in der Sekundärwicklung störungsfrei. Um dennoch hohe Sensibilität als Diebstahlsüberwachungsvorrichtung zu erreichen bedarf es einer sehr aufwändigen Messschaltung um auch kleine Änderung der Oszillatorfrequenz feststellen zu können und es ist erforderlich, dass die Sekundärwicklung einige Windungen hat.

Die der Erfindung zu Grunde liegende Aufgabenstellung besteht darin, eine Warnvorrichtung gegen das Eindringen von Personen in den Laderaum eines Lastkraftwagens zu schaffen. Die Vorrichtung soll schon ansprechen, bevor durch eine eindringende Person ein Teil der Umgrenzung zerstört wird. Die Vorrichtung soll aber auch automatisch besser selektiv vor dem Eindringen warnen als dies Überwachungseinrichtungen, welche auf Infrarot-Bewegungssensoren beruhen, tun. Die Vorrichtung soll unauffällig und robust ausführbar sein.

Die Aufgabe der Erfindung wird durch eine elektronische Warnvorrichtung gemäß Anspruch 1 gelöst.

Für das Lösen der Aufgabe wird vorgeschlagen einen Sensor zu verwenden, welcher auf dem eingangs beschriebenen, auf Leo Theremin zurückgehenden Prinzip beruht, wonach die Schwebung zwischen zwei hochfrequenten elektrischen Signalen ausgewertet und/oder hörbar gemacht wird, wobei eines der beiden hochfrequenten elektrischen Signale durch Annäherung eines elektrisch leitfähigen Körpers veränderbar ist, indem dieser Körper mit mindestens einem solchen elektrischen Schaltungsteil in elektromagnetische Wechselwirkungen tritt, durch welchen die Frequenz eines der hochfrequenten elektrischen Signale mitbestimmt wird.

Erfindungsgemäß wird vorgeschlagen, als jenen besagten elektrischen Schaltungsteilteil, durch welchen die Frequenz eines der hochfrequenten elektrischen Signale mitbestimmt wird, eine isolierte elektrische Leitung vorzusehen, welche an dem vor Eindringen zu schützenden Bereich verläuft, und weiters als Wicklung um einen ferromagnetischen Kern verläuft, um welchen auch eine Spule verläuft, welche induktiver Teil des Schwingkreises für die Erzeugung einer hochfrequenten elektrischen Schwingung ist.

In einer bevorzugten Ausführungsform ist die besagte elektrische Leitung die Zollschnur eines Lastkraftwagens. Damit erhält die ohnedies vorhandene Zollschnur eine wertvolle Zusatzverwendung.

In einer weiter bevorzugten Ausführungsform verläuft die Zollschnur nur in einer einzigen Windung um den besagten, gemeinsamen ferromagnetischen Kern. Das ist besonders einfach und platzsparend zu realisieren und der praktische Versuch beweist, dass es trotz der damit verbundenen, relativ niedrigen transformatorischen Verkopplung, sehr gut funktioniert.

Die Erfindung wird an Hand einer beispielhaften Ausführung näher erklärt.

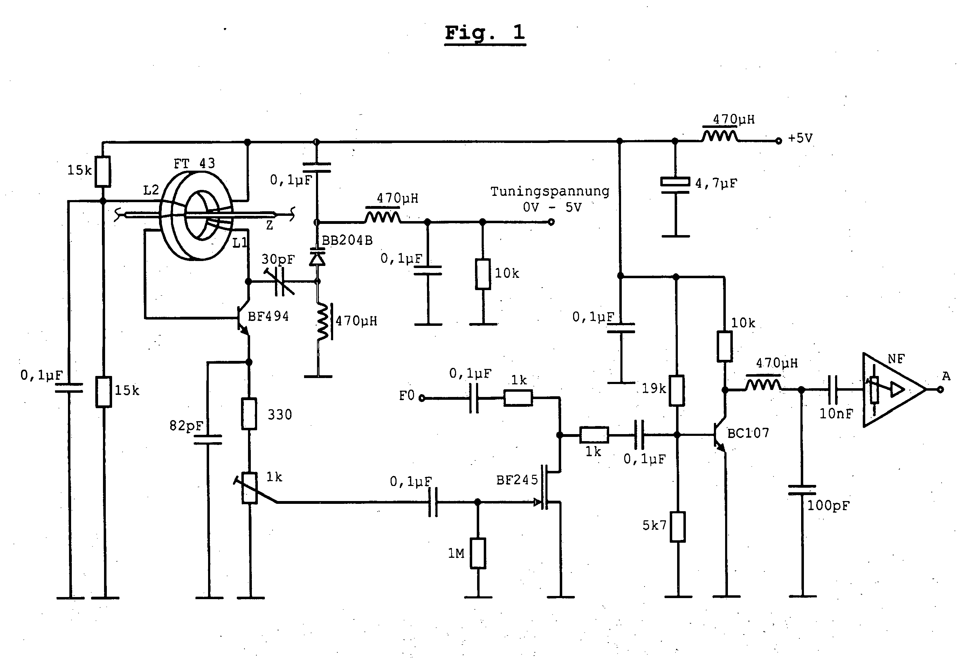

Fig. 1: ist ein Schaltplan des zentralen Teils einer beispielhaften erfindungsgemäßen Vorrichtung.

In der beispielhaften Schaltung gemäß Fig. 1 bedeuten die bei den Bauteilen angegebenen Zeichenfolgen zumeist Werte oder Bezeichnungen, welche gemäß den diesbezüglich in der Fachwelt üblichen Bezeichnungsweisen elektronische Schaltungsteile ausreichend eindeutig kennzeichnen, dass damit die Schaltung nachbaubar ist. (Entweder bedeuten die Zeichenfolgen den Wert der am meisten relevanten physikalischen Größe eines Bauteils, oder die Bezeichnung unter welcher ein Bauteil wie z.B. ein bestimmter Transistor in den Katalogen eines Herstellers zu finden ist.) Es sei klargestellt, dass diese angegebenen Werte und Bezeichnungen nur einen beispielhaften Spezialfall einer Realisierung innerhalb des allgemeineren erfindungsgemäßen Funktionsprinzips darstellen.

Die beispielhafte erfindungsgemäße Schaltung gemäß Fig. 1 wird mit +5 Volt Betriebsspannung versorgt.

In der Schaltung kommen zwei hochfrequente elektrische Spannungen vor. Eine dieser Spannungen wird an der mit "F0" bezeichneten Eingangsklemme von einer externen Quelle zugeführt. Sie hat eine konstante Frequenz von 13,56 MHz bei 80 mVss (Spitze-Spitze-Spannung beträgt 80 mV). Dies entspricht einem Leistungspegel von -22 dBm.

Die zweite hochfrequente Spannung wird in der Schaltung durch eine steuerbare, schwingfähige Schaltungsanordnung erzeugt. Diese schwingfähige Schaltungsanordnung ist in Fig. 1 im rechten Zeichnungsteil dargestellt. Sie umfasst als wesentlichste Teile den ferromagnetischen Ringkern FT43, die darum geführten Wicklungen, welche miteinander magnetisch gekoppelte Induktivitäten L1, L2 darstellen, den Transistor BF 494 sowie den zwischen dem Emitter dieses Transistors und Masse geschalteten Kondensator mit 82 pF. Die Reihenschaltung der durch eine Spule L1 am Ringkern FT 43 realisierten Induktivität mit dem Kondensator 82 pF wäre bei Anlegen einer elektrischen Gleichspannung an sich schon ein resonanzfähiges schwingungsfähiges System, wobei sich die Resonanzfrequenz durch die Formel 1/(2*Pi*Wurzel(L*C)) errechnen ließe.

Indem wie in Fig. 1 dargestellt statt einer einfachen Induktivität zwei Induktivitäten L1, L2 verwendet werden und indem zwischen Induktivitäten und Kondensator ein Transistor in Serie geschaltet wird und indem obendrein die beiden Induktivitäten nach Art der Spulen eines Transformators über den gemeinsamen Ringkern FT 43 transformatorisch miteinander in Wechselwirkung stehen, wobei die Induktivität L1 mit dem Kollektor des Transistors verbunden ist und die zweite Induktivität L2 mit der Basis des Transistors, wird bei Anlegen einer Gleichspannung ebenfalls ein resonanzfähiges, schwingungsfähiges elektrisches System geschaffen. Die Resonanzfrequenz dieses Systems ist allerdings nicht so einfach zu berechnen und sie ist obendrein schon durch kleinste Veränderungen von physikalischen Eigenschaften einzelner Schaltungsteile sowie durch kleine Veränderungen von elektrischen oder magnetischen Kopplungen zwischen einzelnen Schaltungsteilen deutlich veränderbar.

An der Eingangsklemme "Tuningspannung 0V-5V" kann eine als "Tuningspannung" bezeichnete Gleichspannung angelegt werden, welche über die in dem anschließenden Schaltungszweig dargestellten Schaltungsteile wie unter anderem die Kapazitätsdiode BB204B und den steuerbaren Kondensator mit maximal 30 pF Kapazität auf das elektrische Potential am Kollektor des Transistors BF494 wirkt, mit welchem der Transistor mit einer Spule des Ringkerns FT 43 verbunden ist.

Sowohl durch Veränderung der Tuningspannung als auch durch Veränderung des erwähnten einstellbaren Kondensators mit maximal 30 pF Kapazität kann die Frequenz der schwingfähigen Schaltungsanordnung rund um den Transistor BF494 verändert und damit eingestellt werden.

Typischerweise sollte man im Zuge von Tätigkeiten zur Erstinbetriebnahme der Vorrichtung, nach dem Anlegen der Versorgungsspannung, als Tuningspannung etwa den Mittelwert des Einstellbereichs, also 2,5 V anlegen und dann den einstellbaren Kondensator so verändern, dass die Schwingungsfrequenz der beschriebenen schwingfähigen Schaltungsanordnung rund um den Transistor BF494 gleich der Frequenz am Eingang F0 ist (also 13,56 MHz). Den einstellbaren Kondensator kann man dann "für immer" in der so gefundenen Stellung belassen. Man kann dadurch, durch Veränderung der Tuningspannung, die Schwingungsfrequenz nach unten und nach oben etwa gleich weit verändern. (Auf Grund gesetzlicher Vorgaben sollte die Schwingfrequenz jedenfalls innerhalb des Bereichs 13,56 MHz +/- 7 kHz liegen. Man versucht die Einstellungen so zu treffen, dass man durch Änderung der Tuningspannung einen möglichst großen Teilbereich dieses zulässigen Bereichs erreichen kann.)

Die Ausgangsspannung der den Transistor BF494 enthaltenden schwingfähigen Schaltungsanordnung wird an dem ohmschen Spannungsteiler mit 1k Gesamtwiderstand (In Fig. 1 unten, vierter Zweig von links) abgenommen und zwecks Wegfilterung des Gleichanteils über einen Kondensator mit 0,1 µF an die Gate-Elektrode des Feldeffekttransistors BF245 geführt. Die Eingangsklemme F0 ist über eine Serienschaltung aus einem Kondensator (0,1 µF) und einen ohmschen Widerstand (1k) mit der Drain-Elektrode dieses Feldeffekttransistors verbunden, dessen Source-Elektrode an Masse liegt. Das führt dazu, dass an der Drain-Elektrode eine Mischsignalspannung aus der an der Eingangsklemme angelegten Eingangsspannung mit der Frequenz F0 und der durch den Schwingkreis in der Schaltung erzeugten Spannung gebildet wird, welche neben hochfrequenten Signalanteilen auch einen niederfrequenten Signalanteil enthält, dessen Frequenz die Differenz der beiden Hochfrequenzen ist. Von dem Mischsignal wird der Gleichanteil weggefiltert (Kondensator 0,1µF) und der verbleibende Wechselanteil wird durch die Verstärkerschaltung, welche den Transistor BC107 enthält, verstärkt. Von der verstärkten Spannung werden durch die Induktivität 470µH und den Kondensator 100pF (In Fig. 1 links, mittlere Höhe) der hochfrequente Signalanteil (überwiegend) und durch den Kondensator 10nF der Gleichanteil weggefiltert. Das verbleibende, niederfrequente Wechselspannungssignal wird als Eingangsspannung an den Niederfrequenz-Verstärker NF geführt. Die an der Ausgangsklemme A anliegende Ausgangsspannung steht für weitere Signalverarbeitung bereit.

Vorteilhafter Weise wird die Tuningspannung, also jene Spannung mit welcher die Eingangsklemme "Tuningspannung 0V-5V" versorgt wird durch eine Regelschaltung bereitgestellt, welche in regelmäßigen Zeitabständen, beispielsweise einmal je Minute, in Abhängigkeit von der Frequenz der Spannung an der Ausgangsklemme A die Tuningspannung ändert, sodass die Schwingfrequenz der schwingfähigen Schaltungsanordnung, welche den Ringkern FT 43 und den Transistor BF 494 enthält, an jene Frequenz angeglichen wird, welche an der Eingangsklemme F0 anliegt.

Um den Ringkern FT 43 sind nicht nur Spulen angeordnet, welche mit dem Transistor BF494 verbunden sind. Es führt auch eine elektrisch isolierte Leitung Z durch den Ringkern FT 43 und bildet somit um den Ringkern FT 43 eine Spule mit nur einer einzigen Windung. Diese Spule ist mit den Spulen die die Induktivitäten L1 und L2 bilden, über den Ringkern FT 43 als gemeinsamen Leitungskörper für den durch Stromfluss in den Spulen hervorgerufenen magnetischen Fluss, nach Art der unterschiedlichen Spulen eines Transformators transformatorisch verkoppelt. (Stromfluss in den Spulen bewirkt magnetischen Fluss im Ringkern. Änderung des magnetischen Flusses im Ringkern induziert Spannung in den Spulen.) In einem besonders vorteilhaften Anwendungsfall ist die Leitung Z die Zollschnur eines Lastkraftwagens, welche als mit einer elektrischen Isolierschichtung ummantelter Draht ausgeführt ist.

Die Resonanzfrequenz der schwingfähigen Schaltungsanordnung zu welcher der Ringkern FT 43 gehört ist sehr empfindlich gegen Veränderungen von elektrischen Eigenschaften der Spulen, welche um den Ringkern angeordnet sind. Überraschenderweise ist sie derart empfindlich, dass schon eine Veränderung der Kapazität der Leitung Z gegen Erde, wie sie beispielsweise dann stattfindet, wenn die Leitung Z eine Zollschnur ist und sich ein Mensch bis auf wenige cm an diese annähert, ausreicht um die Resonanzfrequenz so stark zu verändern, dass die Schaltung am Ausgang A ein durchaus merkbares Signal liefert.

Indem es ausreicht, dass mit der Leitung Z am Ringkern FT 43 eine einzige Windung gebildet wird, braucht die Leitung Z nur einmal durch den Ringkern durchgeführt zu werden. Im Fall dass die Leitung Z eine Zollschnur ist, wäre es ungleich umständlicher und platzaufwendiger, wenn mehrere Windungen erforderlich wären. Damit eine Veränderung der Impedanz der Leitung Z - wie sie dann stattfindet, wenn sich jemand an sie annähert - stark auf jene Spule L2 durchschlägt, welche auch um den Ringkern FT 43 verläuft und mit der Basis des Transistors BF 494 verbunden ist, soll diese Spule L2 nur sehr wenige Windungen aufweisen. Über die Anzahl der Windungen jener weiteren Spule L1, welche auch um den Ringkern FT 43 verläuft und mit dem Kollektor des Transistors BF 494 verbunden ist, wird vor allem die Resonanzfrequenz der schwingfähigen Schaltungsanordnung grob einstellbar. Im dargestellten Beispiel werden sehr gute Ergebnisse erzielt, wenn die mit der Basis verbundene Spule L2 zwei Windungen hat und wenn die mit dem Kollektor verbundene Spule L1 vier Windungen hat.

Wie auch bei Metallsuchgeräten üblich, ist es vorteilhaft, das Ausgangssignal der Schaltung, welches an der Ausgangsklemme A, anliegt, nicht einfach an einen Lautsprecher zu führen, sondern es in eine Logikschaltung - welche unter Umständen noch mehr Eingänge haben kann - einzulesen, auszuwerten und in Abhängigkeit von der Auswertung für den Menschen wahrnehmbare Signale zu generieren oder auch nicht. Beispielsweise kann man einstellen, dass Warnsignale nur gegeben werden können, wenn die Frequenz des Signals (welches ja in Form einer Wechselspannung vorliegt) einen Mindestwert überschritten hat oder wenn die Frequenzänderung pro Zeit einen Mindestwert überschritten hat. In dem Fall, dass die Warnvorrichtung an einem Fahrzeug angebracht ist, kann man beispielsweise durch die Steuerung auch vorsehen, dass Warnsignale nur gegeben werden können, wenn die Geschwindigkeit des Fahrzeuges niedriger ist als eine vorgegebene Grenze.

Wenn die Leitung Z eine Zollschnur ist, welche um die Ladefläche eines Lastkraftwagens herum verläuft, ist eine sehr gute selektive Warnwirkung erreichbar. Es ist einstellbar, dass die Warnvorrichtung anspricht, wenn sich eine Person mit einer Gliedmaße etwa 10 cm an die Zollschnur annähert oder wenn die Zollschnur bewegt wird, weil die Plane des Lastkraftwagens bewegt wird. Die Zollschnur spricht dabei nicht an, wenn sich beispielsweise eine Katze oder ein Hund (sofern er nicht so groß ist wie ein Mensch) am Lastkraftwagen bewegt oder wenn Passanten am Trottoir neben einem geparkten LKW vorbeigehen. Überdies ist die Warnvorrichtung unauffällig, die Zollschnur braucht nicht beschädigt zu werden und der mechanisch empfindlichste Teil, nämlich die Schaltung, kann gut geschützt und versteckt angeordnet werden.

In einer Abwandlung zu der beschriebenen Bauweise könnte man den veränderlichen Schwingkreis auch realisieren, indem man ihn ohne Transistor einfach als Serien- oder Parallelschaltung einer In duktivität und einer Kapazität ausführt, die Induktivität als Spule auf einem ferromagnetischen Kern ausführt, auf welchem die Leitung Z eine weitere Spule ist und indem man den Schwingkreis von Zeit zu Zeit von außen durch einen Impuls anregt. Die an sich sehr vorteilhafte Neigung zu Frequenzänderungen wäre sehr viel geringer als bei der in Fig. 1 dargestellten Schaltung. Vieles könnte man durch erhöhten Aufwand für das nachfolgende Detektieren von kleineren Frequenzänderungen wieder wettmachen. Vermutlich wäre es erforderlich, die Leitung Z in mehreren Windungen um den Transformatorkern (Ringkern FT 43) zu führen.

In den nachfolgenden Patentansprüchen werden als Positionsbezeichnungen Zeichenfolgen verwendet, welche in Fig. 1 zur Beschreibung der dort beispielhaft vorgeschlagenen Bauteile vorgesehen sind. Es sei ausdrücklich darauf hingewiesen, dass die Verwendung dieser Positionsbezeichnungen in den Ansprüchen nur die Auffindbarkeit der Bauteile in der beispielhaften Schaltung erleichtern soll und keinesfalls als Einschränkung des Schutzbegehrens auf die Verwendung von exakt solchen Bauteilen zu verstehen ist.

## Patentansprüche

1. Elektronische Warnvorrichtung gegen das Eindringen von Personen in einen abzusichernden Bereich, wobei die Warnvorrichtung eine Schaltung aufweist, in welcher die Schwebung zwischen zwei hochfrequenten elektrischen Signalen, von denen eines in seiner Frequenz durch Annäherung eines elektrisch leitfähigen Körpers veränderbar ist, ausgewertet und/oder hörbar gemacht wird, wobei zur Erzeugung des veränderbaren hochfrequenten elektrischen Signals eine schwingfähige Schaltungsanordnung vorhanden ist, welche eine Kapazität (82pF) und eine Induktivität (L1) aufweist, welche als Spule um einen ferromagnetischen Kern (FT 43) ausgebildet ist, wobei eine weitere elektrisch isolierte Leitung (Z) als mindestens eine Windung um den ferromagnetischen Kern (FT 43) verläuft und weiter am Rand des abzusichernden Bereiches verläuft,
**dadurch gekennzeichnet, dass**
die schwingfähige Schaltungsanordnung neben der Leitung (Z) und der Induktivität (L1) noch eine weitere Induktivität (L2) aufweist, welche als Spule um den gemeinsamen ferromagnetischen Kern (FT 43) ausgebildet ist, dass zwischen der Kapazität (82 pF) und den beiden Induktivitäten (L1, L2) ein Spannungsverstärker (BF 494) geschaltet ist, wobei zwischen der Kapazität (82 pF) und der einen Induktivität (L1) die gesteuerte Spannung des Spannungsverstärkers anliegt und zwischen der Kapazität (82 pF) und der zweiten Induktivität (L2) die Steuerspannung des Spannungsverstärkers anliegt.

2. Warnvorrichtung nach Anspruch 1, **dadurch gekennzeichnet, dass** die Leitung (Z) die Zollschnur eines Lastkraftwagens ist.

3. Warnvorrichtung nach Anspruch 1 oder 2, **dadurch gekennzeichnet, dass** die Leitung (Z) in nur einer einzigen Windung um den ferromagnetischen Kern (FT 43) verläuft.

4. Warnvorrichtung nach Anspruch 3, **dadurch gekennzeichnet, dass** die Induktivität (L2) als Spule mit zwei Windungen um den ferromagnetischen Kern (FT 43) ausgebildet ist.

## Claims

1. Electronic warning device to protect against intrusion of persons in an area to be protected, whereby the warning device includes a switch in which the floating between two high-frequency electrical signals is evaluated and/or made audible, whereby the frequency of one signal is alterable in case a conductible body approaches, whereby an oscillatory circuit, which has a capacitor (82 pF) and an inductor (L1), which is designed as a coil around a ferro-magnetic core (FT 43), is present to create the alterable high-frequency electrical signal, whereby an additional electrically insulated wire (Z) with at least one winding runs around the ferro-magnetic core (FT 43) and along the edge of the area to be protected,
and **characterised in**
**that** the oscillatory circuit near the wire (Z) and the indicator (L1) also has another inductor (L2), which is designed as a coil around the common ferro-magnetic core (FT 43), that there is a voltage amplifier (BF 494) between the capacitor (82 pF) and the two inductors (L1, L2), whereby the controlled voltage of the voltage amplifier is between the capacitor (82 pF) and the first inductor (L1) and the control voltage of the voltage amplifier is between the capacitor (82 pF) and the second inductor (L2)

2. Warning device according to Claim 1, **characterised in that** the wire (Z) is the customs seal string of a heavy goods vehicle.

3. Warning device according to Claim 1 or 2, **characterised in that** the wire (Z) is wound around the ferro-magnetic core (FT 43) with just one winding.

4. Warning device according to Claim 3 **characterised in that** the inductor (L2) is a coil with two windings wound around the ferro-magnetic core (FT 43).

## Revendications

1. Dispositif d'avertissement électronique pour empêcher des personnes de pénétrer dans une zone à protéger, le dispositif d'avertissement présentant un circuit, dans lequel la fréquence de battement entre deux signaux électriques haute fréquence, la fréquence de l'un d'eux pouvant être modifiée en rapprochant un corps électriquement conducteur, est analysée ou rendue audible, dans lequel, pour produire le signal électrique haute fréquence variable il y a un agencement de circuit oscillant qui présente une capacité (82 pF) et une inductance (L1) réalisée sous la forme d'une bobine autour d'un noyau ferromagnétique (FT 43), dans lequel une autre conduite isolée électriquement (Z) s'étend sous la forme d'au moins une spire autour du noyau ferromagnétique (FT 43) et se prolonge sur le bord de la zone à protéger,
**caractérisé en ce que**
l'agencement de circuit oscillant présente outre la conduite (Z) et l'inductance (L1) une autre inductance (L2) réalisée sous la forme d'une bobine autour du noyau ferromagnétique commun (FT 43), **en ce qu'**il est couplé entre la capacité (82 pF) et les deux inductances (L1, L2) un amplificateur de tension (BF 494),la tension commandée de l'amplificateur de tension étant montée entre la capacité (82 pF) et la première inductance (L1) et la tension de commande de l'amplificateur de tension étant montée entre la capacité (82 pF) et la deuxième inductance (L2).

2. Dispositif d'avertissement selon la revendication 1, **caractérisé en ce que** la conduite (Z) est la bande du scellement douanier d'un camion.

3. Dispositif d'avertissement selon la revendication 1 ou 2, **caractérisé en ce que** la conduite (Z) ne s'étend que dans une seule spire autour du noyau ferromagnétique (FT 43).

4. Dispositif d'avertissement selon la revendication 3, **caractérisé en ce que** l'inductance (L2) est réalisée sous la forme d'une bobine avec deux spires autour du noyau ferromagnétique (FT 43).
